# EUROPÄISCHE PATENTSCHRIFT

(11) **EP 1 544 629 B1**
(45) Veröffentlichungstag und Bekanntmachung des Hinweises auf die Patenterteilung: **15.06.2016**
(21) Anmeldenummer: 04028524.9
(22) Anmeldetag: 02.12.2004
(51) Int. Cl.: G01R 22/06

(54) **Anschlussvorrichtung für einen Stromzähler**
Connecting device for an electricity meter
Dispositif de connexion pour un compteur d'électricité

(30) Priorität: 17.12.2003 DE 20319726 U; 19.01.2004 DE 102004002856
(43) Veröffentlichungstag der Anmeldung: 22.06.2005
(73) Patentinhaber: Hager Electro GmbH, 66131 Saarbrücken (DE)
(72) Erfinder: Kelaiditis, Konstantin, Dr.-Ing., 66386 St. Ingbert (DE); Zimmermann, Michael, 66399 Mandelbachtal (DE); Clemens, Guntram, Dr.-Ing., 90409 Nürnberg (DE)
(74) Vertreter: Nuss, Laurent

(56) Entgegenhaltungen:
- EP-A1- 0 763 875
- DE-A1- 10 052 998
- DE-A1- 10 054 771
- DE-A1- 10 313 999
- DE-B- 1 051 968
- DE-C1- 10 216 209
- DE-U1- 8 519 135
- DE-U1- 9 313 573
- DE-U1- 9 406 938
- DE-U1- 29 901 587
- DE-U1-202004 009 456
- FR-A- 2 461 377
- WISY M: "VDN - LASTENHEFT ELEKTRONISCHE HAUSHALTSZAEHLER, PASSAGE", VDN - LASTENHEFT ELEKTRONISCHE HAUSHALTSZAEHLER, XX, XX, vol. .5, 10 April 2003 (2003-04-10), pages 1-22, XP008062908,
- ANONYMOUS: 'EHZ VDN-LASTENHEFT ELEKTRONISCHE HAUSHALTSZAEHLER' VDN - LASTENHEFT ELEKTRONISCHE HAUSHALTSZAEHLER, XX, XX Bd. V1.01, 20 Juni 2004, Seiten 1 - 41, XP007900451

## Beschreibung

Die Erfindung betrifft Anschlussvorrichtung für einen Stromzähler, der ein Gehäuse aufweist, von dessen gegen eine Tragplatte der Anschlussvorrichtung anlegbarem Boden durch Öffnungen in der Tragplatte hindurchführbare Kontaktstücke entsprechend wenigstens einer Stromphase vorstehen, welche durch Verschiebung des Stromzählers auf der Tragplatte mit stromzu- und - abführenden Anschlusselementen auf der Rückseite der Tragplatte verbindbar sind.

Anschlussvorrichtungen solcher Art gehen aus den Patentanmeldungen DE 100 52 998A 1 und DE 103 13 999 A 1 der Anmelderin hervor.

In der FR 2 461 377 ist eine Kindersicherung für Steckdosen, die als Anschlussvorrichtung für Steckdosenstromzähler dienen können, beschrieben. Im geschlossenen Zustand sind die Öffnungen einer solchen Steckdose durch eine Platte, die verdrehbar gelagert ist und zwei den Öffnungen für die Kontakte entsprechende Löcher aufweist, verschlossen. Um einen Stecker einzustecken, wird die Platte mit Hilfe der Steckerkontakte so weit gedreht, bis die Löcher über den Öffnungen liegen und der Stecker in die Steckdose eingeschoben.

Die DE 299 01587 U1 beschreibt eine Sicherheitssteckdose, die auf ihrer Rückseite einen beweglichen Schlitten aufweist, der durch einen auf der Vorderseite der Steckdose angeordneten Knopf verschiebbar ist. Der Schlitten ist mit zwei Öffnungen versehen, die den Öffnungen für Kontaktelemente eines Steckers entsprechen. Zum Verschließen der Steckdose wird der Schlitten derart angeordnet, dass die Öffnungen des Schlittens zu den Öffnungen der Steckdose zueinander versetzt sind. Soll ein Stecker eingeführt werden, werden die Öffnungen von Schlitten und Steckdose übereinander geschoben.

Aus der DE 100 54 771 A 1 geht eine Befestigungs- und Kontaktiereinrichtung für einen elektronischen Haushaltszähler hervor. In einer ersten Stellung der Befestigungs- und Kontaktiereinrichtung kann kein Strom zur Kundenanlage fließen, da die Zu- und Abgangsleitungen der Befestigungs- und Kontaktiereinrichtung getrennt und verdeckt sind. In einer zweiten Stellung der Befestigungs- und Kontaktiereinrichtung werden die Zu- und Abgangsleitungen mittels der zugeordneten Überbrückungseinrichtungen überbrückt und sind die Zu- und Abgangsleitungen zugänglich, so dass der Elektrizitätszähler einsetzbar ist. In einer dritten Stellung der Befestigungs- und Kontaktiereinrichtung erfolgt mittels der Arretiereinrichtung eine Verriegelung des Elektrizitätszählers, wobei gleichzeitig die Überbrückungsvorrichtungen in einen nicht-brückenden Zustand überführt werden. Alle drei Stellungen sind durch Betätigung eines Griffs einstellbar.

Aus dem VDN-Lastenheft "Elektronische Haushaltszähler", Entwurf, Version 0.5 vom 10.04.2003, geht ein elektronischer Haushaltszähler mit einem Gehäuse und mit flachen, senkrecht auf der Gehäuserückseite angeordneten Steckstiften hervor.

Der vorliegenden Erfindung liegt die Aufgabe zugrunde, eine Anschlussvorrichtung der eingangs genannten Art zu schaffen, die bei abgenommenem Zähler berührungs-und manipulationssicher ist.

Die diese Aufgabe lösende Anschlussvorrichtung nach der Erfindung ist dadurch gekennzeichnet, dass ein auf der dem Stromzähler abgewandten Seite der Tragplatte der Anschlussvorrichtung angeordneter, parallel zur Tragplatte bewegbarer und Öffnungen aufweisender Schieber vorgesehen ist, dessen Öffnungen in einer ersten Stellung des Schiebers zu den Öffnungen in der Tragplatte ausgerichtet sind und welcher in einer zweiten Stellung die Öffnungen in der Tragplatte verschließt, und dass der Schieber in der ersten Stellung durch die Kontaktstücke, welche gegen den jeweiligen Rand der Öffnungen des Schiebers anlegbar sind, bei Verschiebung des Stromzählers auf der Tragplatte den Schieber mitbewegt wird und der Schieber seinerseits Mitnehmer zur Mitbewegung eines die Anschlusselemente kurzschließenden Überbrückungsteils der Anschlussvorrichtung aus einer Überbrückungsstellung in eine Offenstellung aufweist.

In der ersten Stellung kann der Zähler auf die Tragplatte aufgesetzt werden, wobei die Kontaktstücke sowohl die Öffnungen in der Tragplatte als auch im Schieber durchdringen können. Bei abgenommenem Zähler lässt sich der Schieber in die zweite Stellung verschieben, in welcher die Öffnungen in der Tragplatte durch den Schieber verschlossen sind. So lässt sich der Zugang zu den hinter der Tragplatte angeordneten Anschlusselementen versperren und der Schieber ist innerhalb des Gehäuses angeordnet und in seiner Gesamtheit gegen Manipulationen von außen geschützt.

Handelt es sich bei den Öffnungen in der Tragplatte um längliche Öffnungen, so ist der Schieber vorzugsweise quer zur Längsachse der Öffnungen von der ersten in die zweite Stellung bewegbar. In diesem Fall ist nur ein kurzer Verschiebungsweg erforderlich.

Vorzugsweise liegt der Schieber gegen die Tragplatte unmittelbar an. Zum Schieber bzw, der Tragplatte parallele Durchgänge zwischen Schieber und Tragplatte werden so vermieden.

**Hauptantrag**

Das Überbrückungsteil kann ein länglicher Blechstreifen sein, der eine Randausnehmung aufweist, in welche eines der Kontaktstücke ohne elektrischen Kontakt zu dem Überbrückungsteil eingreift. In diesem Fall können platzsparend ein streifenförmiges Kontaktstück und das Überbrückungsteil in Verschiebungsrichtung zueinander fluchtend angeordnet sein.

Zweckmäßig ist in einer solchen Konstruktion der Schieber durch die Kontaktstücke in einer Richtung senkrecht zur Richtung der Bewegung des Schiebers von der ersten in die zweite Stellung bewegbar.

In einer besonders bevorzugten Ausführungsform der Erfindung sind die Öffnungen im Schieber derart gestaltet, dass in einer dritten Stellung des Schiebers das betreffende Kontaktstück sich bei Verschiebung des Stromzählers auf der Tragplatte in dieser Öffnung, ohne den Schieber mitzubewegen, frei bewegen kann. Vorteilhaft lässt sich die Anschlussvorrichtung dann wahlweise mit oder ohne Nutzung des Überbrückungsteils verwenden.

Die genannte Randausnehmung kann eine solche Länge haben, dass sich das betreffende Kontaktstück bei der Verschiebung des Stromzählers auf der Tragplatte in der Randausnehmung frei bewegen kann, ohne gegen das Überbrückungsteil anzustoßen.

Zweckmäßig liegt diese dritte Stellung zwischen der ersten und der zweiten Stellung. Um die dritte Schieberstellung zu erreichen, könnte aber auch eine Bewegung des Schiebers in zur ersten Stellung entgegengesetzter Richtung erfolgen.

In der bevorzugten Ausführungsform der Erfindung sind Führungen derart vorgesehen, dass der Schieber nur in der Offenstellung des Überbrückungsteils in die zweite und dritte Stellung gelangen kann.

In weiterer Ausgestaltung der Erfindung lässt sich der Schieber in der zweiten und/oder dritten Stellung arretieren und die Arretierung ist vorzugsweise plombierbar. Manipulationen an der Anschlussvorrichtung bei abgenommenem Zähler sind ausgeschlossen.

Zweckmäßig kann ferner eine Einrichtung zur Anzeige der Stellung des Schiebers oder/und des Überbrückungsteils vorgesehen sein.

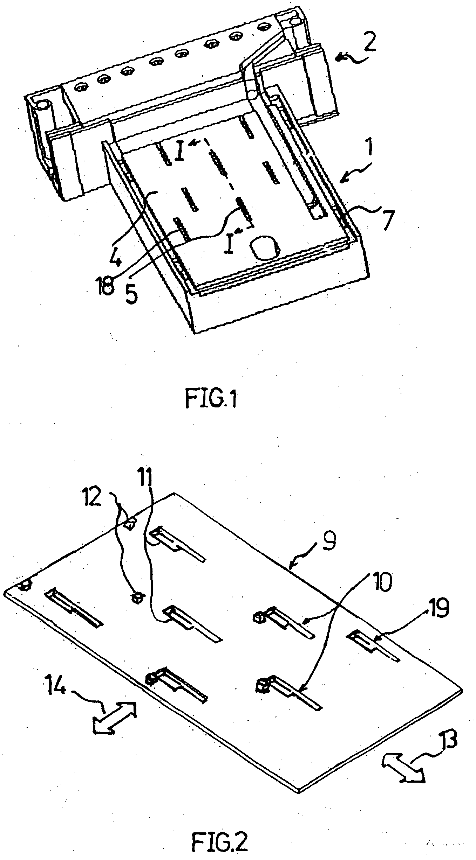

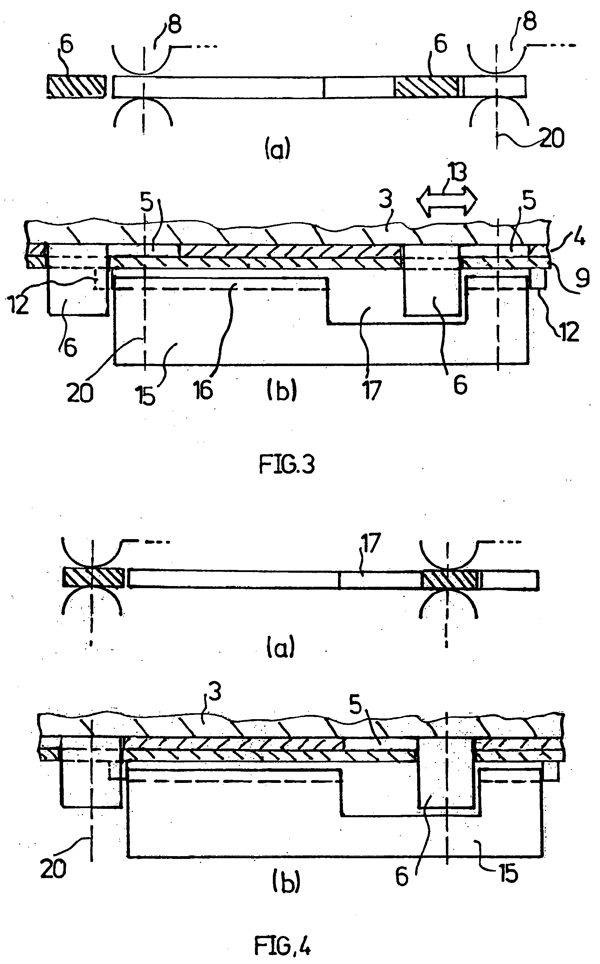

Die Erfindung wird nachfolgend anhand eines Ausführungsbeispiels und der beiliegenden, sich auf dieses Ausführungsbeispiel beziehenden Zeichnungen näher erläutert. Es zeigen:
- Fig.: 1 eine Anschlussvorrichtung für einen Stromzähler nach der Erfindung in einer perspektivischen Ansicht,
- Fig. 2: eine in dem Stromzähler von Fig. 1 verwendete Schieberplatte nach der Erfindung in perspektivischer Ansicht,
- Fig. 3 bis 5: Darstellungen, welche die Verbindung eines Zählers mit Anschlusselementen der Anschlussvorrichtung von Fig. 1 erläutern, und
- Fig. 6: eine Teildarstellung der Schieberplatte von Fig. 2.
Eine in Fig. 1 gezeigte Anschlussvorrichtung weist einen kastenförmigen Teil 1 und einen Teil 2 auf, der eine Anschlussleiste bildet. Mit Hilfe dieser Anschlussvorrichtung ist ein elektronischer Stromzähler 3 (Fig. 3) am Zählerkreuz eines herkömmlichen Zählerplatzes montierbar. Der Kastenteil 1 weist eine Tragplatte 4 für die Aufnahme des Stromzählers 3 auf. In der Tragplatte sind Schlitzöffnungen 5 gebildet, durch welche von dem Stromzähler 3 vorstehende Kontaktstücke 6 hindurchtreten können. Entsprechend drei Stromphasen weist der Zähler drei Paare von Kontaktstücken 6 auf. Ein Schlitz 18 ist für ein dem Anschluss des Neutralleiters an den Zähler dienendes Kontaktstück vorgesehen.

An einander gegenüberliegenden Rändern des Kastenteils 1 sind jeweils zwei Steckschlitze 7 gebildet, in welche von der Rückseite des Stromzählers 3 vorstehende Hakenelemente (nicht gezeigt) für die mechanische Befestigung des Stromzählers an der Anschlussvorrichtung einsteckbar sind.

Die Kontaktstücke 6 lassen sich mit hinter der Tragplatte 4 angeordneten Anschlusselementen 8 verbinden, welche in den Fig. 3 bis 5 schematisch dargestellt sind. Von den Anschlusselementen 8 führen nicht gezeigte Verbindungsstücke zu dem Anschlussleistenteil 2. Zwischen den Anschlusselementen 8 und der Tragplatte 4 ist eine in Fig. 2 gesondert dargestellte Schieberplatte 9 angeordnet. In der Schieberplatte 9 sind den Schlitzöffnungen 5 und der Öffnung 18 entsprechende Öffnungen 10 bzw. 19 für den Durchtritt der Kontaktstücke des Zählers 3 gebildet.

Die schlitzförmigen Öffnungen 10 weisen jeweils eine Aufweitung 11 auf, deren Querschnitt dem Querschnitt der Kontaktstücke 6 entspricht. Von der Platte stehen Mitnehmer 12 vor, deren Funktion weiter unten anhand der Fig. 3 bis 5 näher erläutert wird.

Die hinter der Tragplatte 4 angeordnete Schieberplatte 9 lässt sich innerhalb des Kastenteils 1 in nicht gezeigten Führungen gemäß Pfeil 13 in Längsrichtung der Schlitze 5 und gemäß Pfeil 14 senkrecht zu dieser Richtung verschieben.

Die Anschlusselemente 8 jeder Stromphase lassen sich jeweils durch ein Überbrückungsteil 15 kurzschließen, wie es aus den Fig. 3 bis 5 hervorgeht. Das Überbrückungsteil 15 weist die Form eines Blechstreifens mit einer Abwinklung 16 auf, wobei die Abwinklung 16 in den jeweiligen Fig. 3a bis 5a der Einfachheit halber nicht dargestellt ist.

In einen rechteckförmigen Randausschnitt 17 des Überbrückungsteils 15 greift eines der beiden Kontaktstücke 6 jeder Stromphase ohne elektrischen Kontakt zum Überbrückungsteil ein.

Wie Fig. 3 erkennen lässt, liegt an beiden Enden des Überbrückungsteils ein Mitnehmer 12 gegen die Randabwinklung 16 des Überbrückungsteils 15 an.

In den jeweiligen Fig. 3b bis 5b sind die Anschlusselemente 8 der Einfachheit halber weggelassen. Ihre Lage ist jedoch durch Strichlinien 20 angedeutet. Die gezeigte Schnittdarstellung entspricht z.B. dem Schnitt I-I von Fig. 1.

In der in Fig. 3 gezeigten Stellung ist der Zähler 3 auf die Tragplatte aufgesetzt. Die (nicht gezeigten) Hakenelemente stecken in den Schlitzen 7 am Rand des Kastenteils 1. Die Anschlusselemente 8 sind durch das Überbrückungsteil noch kurzgeschlossen.

Zur mechanischen und elektrischen Verbindung des Stromzählers 3 mit der Anschlussvorrichtung lässt sich der Zähler nun gemäß Pfeil 13 parallel zur Tragplatte 4 verschieben, wobei die Kontaktstücke 6, welche in die Aufweitung 11 der Öffnungen 10 eingreifen, die Schieberplatte 9 mitnehmen und die Schieberplatte 9 ihrerseits über die betreffenden Mitnehmer 12 die jeweiligen Überbrückungsteile 15 verschiebt. In der Anschlussstellung des Zählers, wie sie in Fig. 4 gezeigt ist, stehen die Kontaktstücke 6 im Kontakt mit den Anschlusselementen 8. Der Kurzschluss zwischen den Anschlusselementen 8 durch das Überbrückungsteil 15 ist aufgehoben.

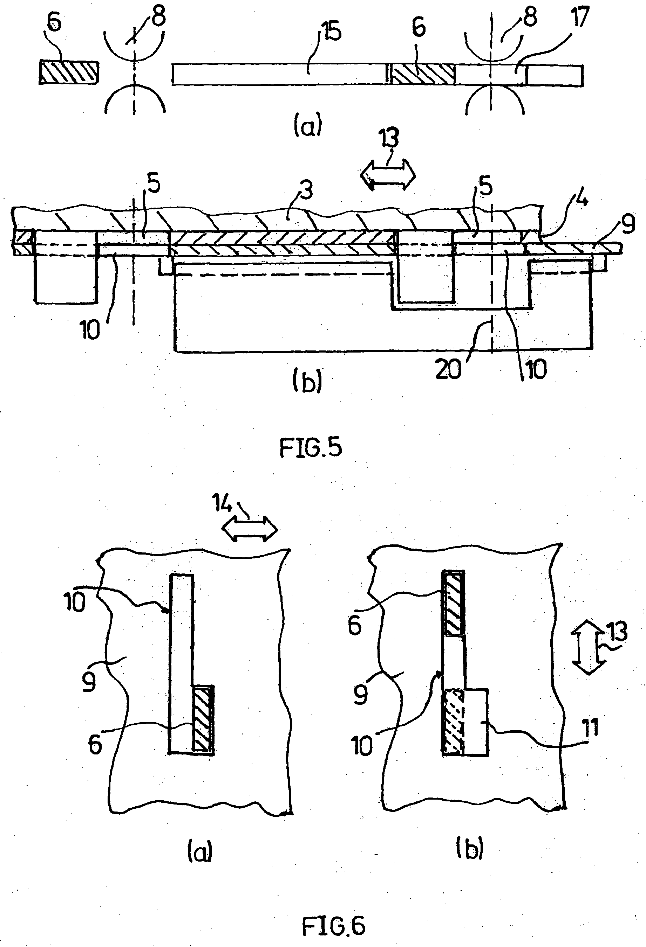

Die Fig. 5 und 6b zeigen einen Zustand, in welchem die Überbrückungsteile 15 die in Fig. 4 gezeigte Position und die Kontaktstücke 6 die in Fig. 3 gezeigte Position einnehmen. Dieser Zustand lässt sich dadurch herstellen, dass die Schieberplatte in der in Fig. 4 gezeigten Stellung gemäß Pfeil 14 senkrecht zur Richtung des Pfeils 13 verschoben wird. Nicht gezeigte Einrichtungen zur Bewegung der Schieberplatte können durch den Stromzähler abgedeckt sein, so dass die Platte nur bei abgenommenem Zähler verschiebbar ist. Es wäre aber auch möglich, am Kastenteil 1 seitlich Einrichtungen vorzusehen, die eine Verschiebung der Platte auch bei aufgesetztem Zähler ermöglichen. Bei abgesetztem Zähler lässt sich die Schieberplatte in Richtung des Pfeils 13 mit Hilfe eines Werkzeugs bewegen, das dem Boden des Stromzählers entspricht, jedoch keine in Schlitze 7 einsteckbaren Verhakungselemente aufweist. Bei der Verschiebung gelangt das jeweilige Kontaktstück 6 aus der in Fig. 6a gezeigten Position in die in Fig. 6b gezeigte Position. Der Zähler 3 kann nun auf der Tragplatte 4 gemäß Pfeil 13 hin und her bewegt werden, ohne die Schieberplatte 9 mitzunehmen, d.h. das betreffende Kontaktstück 6 bewegt sich in der schlitzförmigen Öffnung 10 außerhalb der Aufweitung 11. Die Randausnehmung 17 ist so bemessen, dass es bei der Hin- und Herbewegung nicht zum Anstoß des Kontaktstücks 6 gegen das Überbrückungsteil 15 kommt und zwischen Kontaktstück 6 und Überbrückungsteil 15 ein Luftspalt verbleibt.

Über die Position gemäß Fig. 5 und 6b hinaus lässt sich die Schieberplatte 9 bei abgenommenen Zähler in der Ansicht von Fig. 6 nach rechts in eine Verschlussposition verschieben, in welcher die Schlitzöffnungen 5,18 in der Tragplatte 4 durch die gegen die Tragplatte 4 anliegende Schieberplatte 9 rückseitig verschlossen sind. Die Anschlusselemente 8 und die genannten Verbindungsteile sind dann berührungssicher abgedeckt und gegen unberechtigte Stromentnahme gesichert.

Der in Fig. 5 gezeigte Zustand, in welchem das Überbrückungsteil 15 nicht aktivierbar ist, kann z.B. nach Montage der Anschlussvorrichtung und vor dem Anschluss eines Stromzähler bestehen, so dass während dieser Zeit eine Stromentnahme nicht möglich ist. Die betreffende Verschiebungsstellung der Schieberplatte 9 kann aber auch bei angeschlossenem Zähler eingenommen werden, wenn der Verdacht besteht, dass an der Anschlussvorrichtung Manipulationen vorgenommen werden.

Beide Verschiebungspositionen der Schieberplatte 9 gemäß Pfeil 14 können über nicht gezeigte Einrichtungen arretier- und plombierbar sein.

In der Schieberplatte 9 lässt sich ein Fenster bilden, in welches ein von der Schieberplatte 9 vorstehendes Griffstück für die Bewegung der Schieberplatte hineinragt. Die jeweilige Stellung der Schieberplatte ließe sich durch Skalenstriche an der Schieberund Tragplatte im Bereich des Fensters kenntlich machen.

Zur Verschiebung der Platte könnte auch ein am Längsrand des Kastenteils 1 angeordneter Exzenter dienen, der ggf. in verschiedenen Stellungen arretier- und plombierbar ist.

Zur Führung der Schieberplatte 9 gemäß den Pfeilen 13,14 können Führungsschlitze vorgesehen sein, die zueinander im rechten Winkel stehen, wobei die Führungsschlitze derart angeordnet sind, dass die Platte nur in der in Fig. 5 gezeigten Verschiebungsposition gemäß Pfeil 13 in Richtung des Pfeils 14 verschiebbar ist.

Alternativ zu der beschriebenen Ausführungsform, in welcher die Schieberplatte von den Kontaktstücken abkoppelbar ist, könnten auch die Schieberplatte und das Überbrückungsteil entkoppelbar sein, indem durch Bewegung der Schieberplatte in Richtung des Pfeils 14 die Mitnehmer 12 in eine zum Überbrückungsteil versetzte Stellung gebracht werden. In einer solchen Ausführungsform könnte z.B. die Abwinklung 16 entfallen und die Mitnehmer 12 in Richtung des Pfeils 13 mit den Öffnungen 10 fluchtend angeordnet sein. Die Öffnungen 10 haben dann eine einheitliche Breite, die wenigstens gleich der doppelten Stärke der Kontaktstücke entspricht.

## Patentansprüche

1. Anschlussvorrichtung für einen Stromzähler (3), der ein Gehäuse aufweist, von dessen gegen eine Tragplatte (4) der Anschlussvorrichtung anlegbarem Boden durch Öffnungen (5, 18) in der Tragplatte (4) hindurchführbare Kontaktstücke (6) entsprechend wenigstens einer Stromphase vorstehen, welche mit stromzuund -abführenden Anschlusselementen (8) der Anschlussvorrichtung durch Verschiebung des Stromzählers (3) auf der Tragplatte (4) auf der dem Stromzähler (3) abgewandten Seite der Tragplatte (4) verbindbar sind, wobei
ein auf der dem Stromzähler (3) abgewandten Seite der Tragplatte (4) angeordneter, parallel zur Tragplatte (4) bewegbarer und Öffnungen (10, 19) aufweisender Schieber (9) der Anschlussvorrichtung vorgesehen ist, dessen Öffnungen (10, 19) in einer ersten Stellung des Schiebers (9) zu den Öffnungen (5, 18) in der Tragplatte (4) ausgerichtet sind und welcher in einer zweiten Stellung die Öffnungen (5, 18) in der Tragplatte (4) verschließt,
und der Schieber in der ersten Stellung durch die Kontaktstücke (6), welche gegen den jeweiligen Rand der Öffnungen (10) des Schiebers (9) anlegbar sind, der Schieber in der ersten Stellung durch bei Verschiebung des Stromzählers (3) auf der Tragplatte (4) mitbewegt wird und der Schieber seinerseits Mitnehmer (12) zur Mitbewegung eines die Anschlusselemente (8) kurzschließenden Überbrückungsteils (15) der Anschlussvorrichtung aus einer Überbrückungsstellung in eine Offenstellung aufweist

2. Anschlussvorrichtung nach Anspruch 1,
**dadurch gekennzeichnet,**
**dass** die Öffnungen (5) in der Tragplatte (4) längliche Öffnungen sind und der Schieber (9) quer zur Längsachse der Öffnungen (5, 18) aus der ersten in die zweite Stellung bewegbar ist.

3. Anschlussvorrichtung nach Anspruch 1 oder 2,
**dadurch gekennzeichnet,**
**dass** das Überbrückungsteil (15) eine Randausnehmung (17) aufweist, in welche eines der Kontaktstücken (6) ohne elektrischen Kontakt zu dem Überbrückungsteil (15) eingreift.

4. Anschlussvorrichtung nach einem der Ansprüche 1 bis 3,
**dadurch gekennzeichnet,**
**dass** der Schieber (9) durch die Kontaktstücke (6) in einer Richtung bewegbar ist, die senkrecht zur Richtung der Bewegung des Schiebers (9) von der ersten in die zweite Stellung ist.

5. Anschlussvorrichtung nach Anspruch 3 oder 4,
**dadurch gekennzeichnet,**
**dass** die Öffnungen (10) im Schieber (9) derart gestaltet sind, dass in einer dritten Stellung des Schiebers (9) das betreffende Kontaktstüok (6) sich bei Verschiebung des Stromzählers (3) auf der Tragplatte (4) in der Öffnung (10), ohne den Schieber (9) mitzubewegen, frei bewegen kann.

6. Anschlussvorrichtung nach Anspruch 5 in Kombination mit Anspruch 3,
**dadurch gekennzeichnet,**
**dass** die Randausnehmung (17) eine solche Länge hat, dass sich das Kontaktstück (6) bei der Verschiebung des Stromzählers (3) auf der Tragplatte (4) in der Randausnehmung (17) frei bewegen kann.

7. Anschlussvorrichtung nach Anspruch 5 oder 6,
**dadurch gekennzeichnet,**
**dass** die dritte Stellung zwischen der ersten und zweiten Stellung liegt.

8. Anschlussvorrichtung nach einem der Ansprüche 3 bis 7,
**dadurch gekennzeichnet,**
**dass** der Schieber (9) nur in der Offenstellung des Überbrückungsteils (15) in die zweite und/oder dritte Stellung bewegbar ist

9. Anschlussvorrichtung nach einem der Ansprüche 5 bis 8,
**dadurch gekennzeichnet,**
**dass** der Schieber (9) in der zweiten und/oder dritten Stellungmittels einer Arretierung der Ansclussvorrichtung arretierbar und vorzugsweise die Arretierung plombierbar ist.

10. Anschlussvorrichtung nach einem der Ansprüche 1 bis 9,
**dadurch gekennzeichnet,**
**dass** sie eine Einrichtung zur Anzeige der Stellung des Schiebers (9) oder/und des Überbrückungsteils (15) aufweist.

## Claims

1. Connecting device for an electricity meter (3), which comprises a housing, from the bottom of which, which can be placed against a mounting plate (4) of the connecting device, contact pieces (6), which can be guided through openings (5, 18) in the mounting plate (4), protrude according to at least one current phase, which can be connected to current supplying and current carrying connecting elements (8) of the connecting device by displacing the electricity meter (3) on the mounting plate on the side of the mounting plate (4) facing away from the electricity meter (3),
wherein a slider (9) of the connecting device is provided, which is arranged on the side of the mounting plate (4) facing away from the electricity meter, can be moved parallel to the mounting plate (4) and comprises openings (10, 19), the openings (10, 19) of which are aligned in a first position of the slider (9) relative to the openings (5, 18) in the mounting plate (4) and which closes the openings (5, 18) in the mounting plate (4) in a second position, and
the slider in the first position is moved by contact pieces (6), which can be placed against the respective edge of the openings (10) of the slider (9), on displacing the electricity meter (3) on the mounting plate (4) and the slider comprises drivers (12) for moving a bridging part (15) of the connecting device short-circuiting the connecting elements (8) from a bridging position into an open position.

2. Connecting device according to claim 1,
**characterised in that**
the openings (5) in the mounting plate (4) are elongated openings and the slider (9) can be moved perpendicular to the longitudinal axis of the openings (5,18) from the first to the second position.

3. Connecting device according to claim 1 or 2,
**characterised in that**
the bridging part (15) comprises an edge recess (17), into which one of the contact pieces (6) engages without electrical contact to the bridging part (15).

4. Connecting device according to any one of claims 1 to 3,
**characterised in that**
the slider (9) can be moved by the contact pieces (6) in a direction which is perpendicular to the direction of movement of the slider (9) from the first to the second position.

5. Connecting device according to 3 or 4,
**characterised in that**
the openings (10) in the slider (9) are configured such that in a third position of the slider (9) the relevant contact piece (6) can move freely in the opening (10) on displacement of the electricity meter (3) on the mounting plate (4) without also moving the slider (9).

6. Connecting device according to claim 5 in combination with claim 3,
**characterised in that**
the edge recess (17) has such a length that the contact piece (6) can move freely in the edge recess (17) on the displacement of the electricity meter (3) on the mounting plate (4).

7. Connecting device according to claim 5 or 6,
**characterised in that**
the third position is located between the first and second position.

8. Connecting device according to any one of claims 3 to 7,
**characterised in that**
the slider (9) can be moved into the second and/or third position only in the open position of the bridging part (15).

9. Connecting device according to any one of claims 5 to 8,
**characterised in that**
the slider (9) can be locked in the second and/or third position by means of a lock of the connecting device and preferably the lock can be sealed.

10. Connecting device according to any one of claims 1 to 9,
**characterised in that**
it comprises a device for displaying the position of the slider (9) and/or the bridging part (15).

## Revendications

1. Dispositif de connexion pour un compteur d'électricité (3) qui présente un boîtier, le fond duquel pouvant être appliqué contre une plaque de support (4) du dispositif de connexion, des pièces de contact (6) correspondant à au moins une phase de courant faisant saillie dudit fond, lesdites pièces de contact (6) pouvant être passées à travers des ouvertures (5, 18) dans la plaque de support (4) et pouvant être reliées à des éléments de connexion (8) d'arrivée et de départ de courant du dispositif de connexion par coulissement du compteur d'électricité (3) sur la plaque de support (4) du côté de la plaque de support (4) opposé au compteur d'électricité (3), un coulisseau (9) du dispositif de connexion disposé du côté de la plaque de support (4) opposé au compteur d'électricité (3), déplaçable parallèlement à la plaque de support (4) et présentant des ouvertures (10, 19) étant prévu, dont les ouvertures (10, 19) sont orientées vers les ouvertures (5, 18) dans la plaque de support (4) dans une première position du coulisseau (9) et lequel ferme les ouvertures (5, 18) dans la plaque de support (4) dans une deuxième position, et le coulisseau étant déplacé dans la première position par les pièces de contact (6), lesquelles peuvent être appliquées contre le bord respectif des ouvertures (10) du coulisseau (9), lors du coulissement du compteur d'électricité (3) sur la plaque de support (4) et le coulisseau présentant de son côté des éléments d'entraînement (12) pour déplacer avec eux une partie de pontage (15) du dispositif de connexion, laquelle court-circuite les éléments de connexion (8), d'une position de pontage dans une position d'ouverture.

2. Dispositif de connexion selon la revendication 1,
**caractérisé en ce**
**que** les ouvertures (5) dans la plaque de support (4) sont des ouvertures oblongues et le coulisseau (9) est déplaçable transversalement à l'axe longitudinal des ouvertures (5, 18) de la première dans la deuxième position.

3. Dispositif de connexion selon l'une des revendications 1 ou 2,
**caractérisé en ce**
**que** la partie de pontage (15) présente un évidement marginal (17) dans lequel une des pièces de contact (6) s'engage sans contact électrique avec la partie de pontage (15).

4. Dispositif de connexion selon l'une des revendications 1 à 3,
**caractérisé en ce**
**que** le coulisseau (9) est déplaçable par les pièces de contact (6) dans une direction qui est perpendiculaire à la direction de déplacement du coulisseau (9) de la première dans la deuxième position.

5. Dispositif de connexion selon l'une des revendications 3 ou 4,
**caractérisé en ce**
**que** les ouvertures (10) dans le coulisseau (9) sont formées de façon que, dans une troisième position du coulisseau (9), la pièce de contact (6) concernée puisse se déplacer librement, sans entraîner avec elle le coulisseau (9), dans l'ouverture (10) lors du coulissement du compteur d'électricité (3) sur la plaque de support (4).

6. Dispositif de connexion selon la revendication 5 en combinaison avec la revendication 3,
**caractérisé en ce**
**que** l'évidement marginal (17) a une longueur telle que la pièce de contact (6) peut se déplacer librement dans l'évidement marginal (17) lors du coulissement du compteur d'électricité (3) sur la plaque de support (4).

7. Dispositif de connexion selon l'une des revendications 5 ou 6,
**caractérisé en ce**
**que** la troisième position se situe entre la première et la deuxième position.

8. Dispositif de connexion selon l'une des revendications 3 à 7,
**caractérisé en ce**
**que** le coulisseau (9) est déplaçable dans la deuxième et/ou troisième position seulement dans la position d'ouverture de la partie de pontage (15).

9. Dispositif de connexion selon l'une des revendications 5 à 8,
**caractérisé en ce**
**que** le coulisseau (9) peut être arrêté dans la deuxième et/ou troisième position au moyen d'un dispositif d'arrêt du dispositif de connexion et le dispositif d'arrêt est de préférence plombable.

10. Dispositif de connexion selon l'une des revendications 1 à 9,
**caractérisé en ce**
**qu'**il présente un moyen pour indiquer la position du coulisseau (9) ou/et de la partie de pontage (15).
